(19) Europäisches Patentamt
European Patent Office
Office européen des brevets

(11) **EP 4 306 945 A1**

(12) **EUROPEAN PATENT APPLICATION**

(43) Date of publication:
**17.01.2024  Bulletin 2024/03**

(21) Application number: **22184150.5**

(22) Date of filing: **11.07.2022**

(51) International Patent Classification (IPC):
*G01N 23/2202* (2018.01)    *H01J 37/28* (2006.01)
*H01J 37/304* (2006.01)    *G01N 1/44* (2006.01)
*G01N 23/203* (2006.01)    *G01N 23/2251* (2018.01)
*G01N 23/2276* (2018.01)

(52) Cooperative Patent Classification (CPC):
**G01N 23/2202; H01J 37/02;** G01N 1/44;
G01N 23/203; G01N 23/2251; G01N 23/2276;
G01N 2223/6116; G01N 2223/6462;
G01N 2223/652; H01J 2237/0225; H01J 2237/182;
H01J 2237/2809

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventor: **WIELAND, Marco, Jan-Jaco
5500 AH Veldhoven (NL)**

(74) Representative: **ASML Netherlands B.V.
Corporate Intellectual Property
P.O. Box 324
5500 AH Veldhoven (NL)**

(54) **METHOD OF ASSESSING A SAMPLE, APPARATUS FOR ASSESSING A SAMPLE**

(57)    The present disclosure relates to apparatus and methods for assessing samples (208) using charged particles. In one arrangement, a degassing action is performed by exposing a target area of a sample (208) with charged particles to stimulate degassing. A rate of degassing from the target area is measured during the degassing action. Initiation of an assessing of the sample (208) is controlled based on a characteristic of the measured rate of degassing. The assessing of the sample (208) comprises exposing the target area with charged particles and detecting signal charged particles from the target area.

Fig. 8

**Description**

FIELD

The present disclosure relates to methods and apparatus for assessing a sample using charged particles.

BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which herein are referred to as assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection system may obtain an image representing characteristics of the material structure of the surface of the sample.

It has been observed that impingement of electrons on a surface can stimulate degassing from the surface. Gases produced in this way can cause unwanted deposition of materials on apparatus components that are exposed to the gases. Such deposition can be driven by charged particles and so can occur particularly where charged particles impinge on components in the presence of the gases. The deposition can be reduced or eliminated by pumping outgassed gases away before they can contribute to the deposition, but this is not always practical, particularly where space is limited in the regions where degassing occurs.

SUMMARY

It is an object of the present disclosure to provide methods and apparatus that at least partially address the challenges mentioned above, for example that reduce or eliminate contamination due to deposition of materials originating from charged particle stimulated degassing.

According to an aspect of the invention, there is provided a method of assessing a sample using charged particles, comprising: performing a degassing action by exposing a target area of a sample with charged particles to stimulate degassing; measuring a rate of degassing from the target area during the degassing action; and controlling initiation of an assessing of the sample based on a characteristic of the measured rate of degassing, the assessing of the sample comprising exposing the target area with charged particles and detecting signal charged particles from the target area.

According to an aspect of the invention, there is provided an apparatus for assessing a sample using charged particles, the apparatus comprising: a degassing device configured to expose a target area of the sample with charged particles to stimulate degassing from the target area; a degassing sensor configured to measure a rate of degassing from the target area; an assessment device configured to perform an assessing of the sample by exposing the target area with charged particles and detecting signal charged particles from the target area; and a control system configured to control the assessment device to initiate the assessing of the sample in response an output from the degassing sensor.

According to an aspect of the invention, there is provided a method of assessing a sample using charged particles, comprising: performing a degassing action by exposing a target area of a sample with charged particles to stimulate degassing until a rate of the stimulated degassing falls below a threshold count of the number of molecules of a component of interest, desirably hydrocarbons, degassed per charged particle impinging on the target area, the threshold count desirably being 0.01 molecules degassed per charged particle impinging on the target area; and subsequently assessing the sample by exposing the target area with charged particles and detecting signal charged particles from the target area.

According to an aspect of the invention, there is provided an apparatus for assessing a sample using charged particles, the apparatus comprising: a degassing device configured to expose a target area of the sample with charged particles to stimulate degassing from the target area; an assessment device configured to perform an assessing of the sample by exposing the target area with charged particles and detecting signal charged particles from the target area; and a control system configured to control the assessment device to initiate the assessing of the sample after the degassing device has exposed the target area of the sample with charged particles until a rate of the stimulated degassing has fallen below a threshold count of the number of molecules of a component of interest, desirably hydrocarbons, degassed per charged particle impinging on the target area, the threshold count desirably being 0.01 molecules degassed per charged particle impinging on the target area.

## BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary charged particle beam inspection apparatus.
FIG. 2 is a schematic diagram illustrating an exemplary multi-beam apparatus that is part of the exemplary charged particle beam inspection apparatus of **FIG. 1.**
FIG. 3 is a schematic diagram of an exemplary electron-optical column comprising a condenser lens array, an objective lens array and a detector array.
FIG. 4 is a schematic cross-sectional view of a portion of an objective lens array and detector array of an exemplary arrangement.
FIG. 5 is bottom view of the portion of the detector array of **FIG. 4.**
FIG. 6 is a bottom view of a modified version of the portion of the objective lens array of **FIG. 4**.
FIG. 7 is a schematic diagram of an exemplary electron-optical device comprising an objective lens array and a beam separator.
FIG. 8 is a flow chart depicting an example method of assessing a sample using charged particles.
FIG. 9 is a flow chart depicting a further example method of assessing a sample using charged particles.
FIG. 10 is a flow chart depicting a further example method of assessing a sample using charged particles.
FIG. 11 is a schematic diagram of an example apparatus for assessing a sample having a degassing device, a degassing sensor and an assessment device.

## DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than $1/1000^{th}$ of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

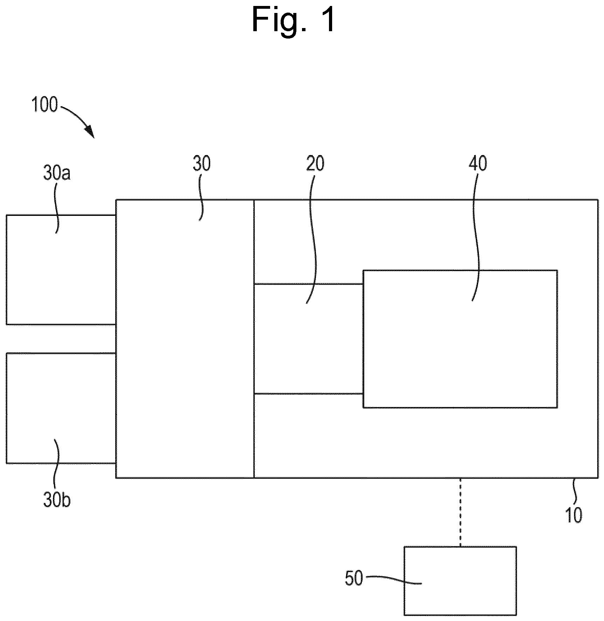

Reference is now made to **FIG. 1**, which is a schematic diagram illustrating an exemplary charged particle beam inspection apparatus 100, which may also be referred to as a charged particle beam assessment system or simply assessment system. The charged particle beam inspection apparatus 100 of **FIG. 1** includes a main chamber 10, a load lock chamber 20, an electron beam apparatus 40, an equipment front end module (EFEM) 30 and a controller 50. The controller may be distributed between different components of the assessment system, including for example in the electron beam apparatus 40. Electron beam apparatus 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be inspected. An electron beam apparatus 40 may comprise a multi-beam electron-optical apparatus.

Controller 50 is signally, for example electronically, connected to electron beam apparatus 40, for example as distributed components of the controller 50. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection apparatus, it should be noted that aspects of the disclosure in their broadest sense are not limited to a chamber housing an electron beam inspection apparatus. Rather, it is appreciated that the foregoing principles may also be applied to other systems and other arrangements of apparatus, that operate under the second pressure.

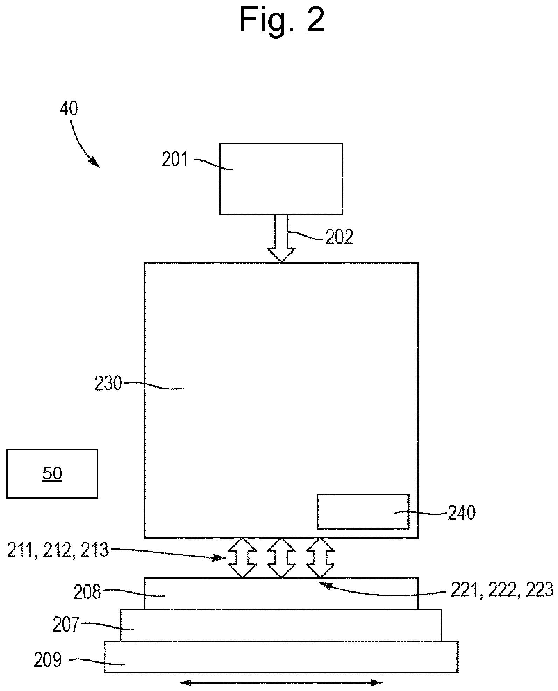

Reference is now made to **FIG. 2**, which is a schematic diagram illustrating an exemplary charged particle beam assessment apparatus 40. The electron beam apparatus 40 may be provided as part of the exemplary charged particle beam inspection system 100 of **FIG. 1**. The electron beam apparatus 40 includes an electron source 201 and a charged particle column (or device) 230. The charged particle device 230 may be referred to or comprise a projection apparatus for directing a primary charged particle beam 202 towards a sample 208. The electron source 201 and associated and component charged particle optical elements may be referred to as an illumination apparatus for generating a primary charged particle beam 202. The assessment apparatus comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The electron beam apparatus 40 further comprises a detector 240. The detector 240 detects signal charged particles (e.g., electrons) from the sample 208. The detector 240 generates detection signals on detection of the signal charged particles.

The electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form the primary electron beam 202.

The charged particle device 230 is configured to convert primary electron beam 202 into a plurality of charged particle beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as beamlets or sub-beams. The plurality of charged particle beams may be referred to collectively as a multi-beam or beam grid. A beam grid with so many beams (e.g. more than a thousand beams) may have a field of view of e.g. more than 0.5mm, for example in the range of 0.5 to 30mm or 1 to 30 mm.

The controller 50 (for example control system comprising distributed controllers) may be connected to various parts of charged particle beam inspection apparatus 100 of **FIG. 1**, such as the electron source 201, the electron detection device 240, the charged particle device 230, and actuated stage 209. The controller 50 may perform various image and signal processing functions. The controller 50 may also generate various control signals to govern operations of the charged particle beam inspection apparatus 100, including operations of the electron beam apparatus 40.

The charged particle device 230 may be configured to focus, for example, beams 211, 212, and 213 onto a sample 208 for inspection and may form three probe spots 221, 222, and 223 on the surface of sample 208. The charged particle device 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles. The secondary electrons typically have electron energy as large as fifty electron volts ($\leq$ 50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to the controller 50 or a signal processing system (not shown which may be part of the controller 50), e.g. to construct images of the corresponding scanned areas of sample 208. The detector 240 may be incorporated at least partly into the charged particle device 230 or may be separate therefrom, for example where a secondary optical column directs secondary electrons to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive the detection signal from the detector 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample 208 based on an imaging signal received from the detector 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under inspection. The reconstructed images can be used to reveal various features of the internal or external structures of sample 208. The reconstructed images can thereby be used to reveal any defects that may exist in and/or on, thus of the sample.

The controller 50 may control actuated stage 209 to move sample 208 during inspection of sample 208, for example to provide a scanning motion of the stage relative to the paths of the primary beams. The controller 50 may enable actuated stage 209 to move sample 208 in a direction such as part of the scanning motion of the stage, preferably continuously, for example at a constant speed, at least during sample inspection. The controller 50 may control movement of the actuated stage 209 so that it changes the speed of the movement of the sample 208 dependent on various parameters. For example, the controller may control the stage speed (including its direction) depending on the characteristics of the inspection steps and/or scans of the scanning process for example as disclosed in EPA 21171877.0 filed 3 May 2021 which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

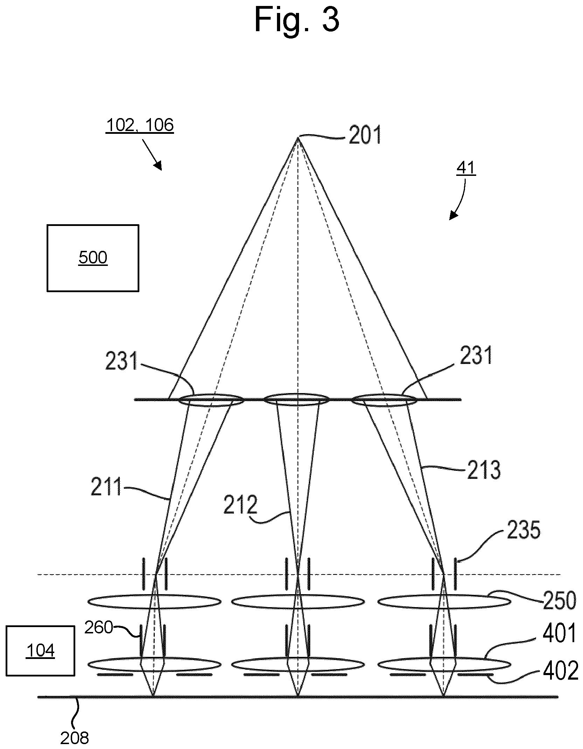

**FIG. 3** is a schematic diagram of an exemplary charged particle device 41 for use in an assessment apparatus. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged particle devices such as those discussed herein, it will be understood that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along a path of a beam grid of a plurality of charged particle beams (which may also be referred to as sub-beams). The electrodes are thus also in series along paths of charged particle beams of the beam grid.

Electron source 201 directs electrons toward an array of condenser lenses 231 forming part of charged particle device 230. The electron source 201 is desirably a high brightness thermal field emitter with a good compromise between brightness and total emission current. There may be many tens, many hundreds or many thousands or even tens of thousands of condenser lenses 231. Condenser lenses of array 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, preferably three, plates, acting as electrodes, with apertures in each plate aligned with apertures in other plates to define paths for charged particle beams through the plates. At least two of the plates are maintained during operation at different potentials to achieve the desired lensing effect. Between the plates of the condenser lens array are electrically insulating plates, for example made of an insulating material such as ceramic or glass, with one or more apertures for the charged particle beams. Additionally or alternatively, one or more of the plates may feature apertures that each have their own electrode, for example with an array of electrodes around their perimeter or arranged in groups of apertures having a common electrode. In a variant, one or more of the plates may comprise multiple portions or strips with multiple apertures. In a further alternative arrangement, a macro collimator is provided instead of the condenser lens array. The macro collimator may act on the beam from the source 201 before the beam has been split into a multi-beam. The macro collimator may be implemented magnetically, electrostatically, or magnetically and electrostatically.

In some embodiments, the condenser lens array is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective beam 211, 212, 213 which is focused at a respective intermediate focus 233. A collimator or an array of collimators may be positioned to operate on the respective intermediate focuses 233. The collimators may take the form of deflectors 235 provided at the intermediate focuses 233. Deflectors 235 are configured to bend a respective beam 211, 212, 213 by an amount effective to ensure that the principal ray (which may also be referred to as the beam axis) is incident on the sample 208 substantially normally (i.e. at substantially 90° to the nominal surface of the sample). Note that in an arrangement with a macro condenser lens, the condenser lens may collimate or contribute to the collimation of the source beam or, in an embodiment, a plurality of beams.

An objective lens array 401 is provided down-beam from the deflectors 235. The objective lens array 501 comprises an objective lens for each beam 211, 212, 213. The objective lens array 401 projects the beams 211, 212, 213 onto the sample 208. The objective lens array 401 may comprise two or more, preferably at least three, plate electrode arrays connected to respective potential sources.

Optionally, a control lens array 250 is provided between the deflectors 235 and the objective lens array 401. The control lens array 250 comprises a control lens for each beam 211, 212, 213. The control lens array 250 provides additional degrees of freedom for controlling properties of the beams 211, 212, 213. The control lens array 250 may comprise two or more, preferably at least three, plate electrode arrays connected to respective potential sources. A function of control lens array 250 is to optimize the beam opening angle with respect to the demagnification of the beam and/or to control the beam energy delivered to the objective lenses, each of which directs a respective beam 211, 212, 213 onto the sample 208. In an embodiment the control lens array may be considered to be part of the objective lens, for example in being additional plates associated with the objective lens array.

Optionally an array of scan deflectors 260 is provided between the control lens array 250 and the objective lens array 401. The array of scan deflectors 260 comprises a scan deflector for each beam 211, 212, 213. Each scan deflector is configured to deflect a respective beam 211, 212, 213 in one or two directions to scan the beam across the sample 208 in one or two directions. Alternatively, a macro scan deflector may be provided to scan the charged particle beams over the sample 208. The macro scan deflector may be provided up-beam of the control lens array 250. In an embodiment such a macro scan deflector may operate on the source beam and may be present with a macro condenser lens.

A detector module 402 of a detector is provided within the objective lenses or between the objective lenses and the sample 208 to detect signal electrons/particles from the sample 208. An exemplary construction of such a detector module 402 is described below. Note that the detector additionally or alternatively may have detector elements up-beam along the primary beam path of the objective lens array 401 or even the control lens array 250. The detector module may be an array of detector elements (e.g. a detector array). Each element may be associated with an individual beam, for example positioned to detect signal particles generated by the individual beam.

The charged particle device 41 of **FIG. 3** may be configured to control the landing energy of electrons on the sample 208 by varying potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. The detector module may be comprised in the objective lens assembly.

The objective lenses can be configured to demagnify the electron beam by a factor greater than 10, desirably in the range of 50 to 100 or more. The objective lenses may comprise three electrodes: a middle electrode, a lower electrode and an upper electrode. The upper electrode may be omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beams.

In some embodiments, the objective lens array assembly comprises a detector having a detector module 402 down-beam of at least one electrode of the objective lens array 401. The detector module 402 may comprise or even take the form of a detector array. In an embodiment, at least a portion of the detector is adjacent to and/or integrated with the objective lens array 401. For example, the detector module 402 may be implemented by integrating a CMOS chip detector into a bottom electrode of the objective lens array 401. Integration of a detector module 402 into the objective lens array may replace a secondary column. The CMOS chip is preferably orientated to face the sample (because of the small distance between sample and the bottom of the electron-optical system, which may for example be in the range of 10 to 400 micron, desirably in the range of 50 to 200 micron, optionally about 100 micron). It is noted that even in situations in which the detector is up-beam of the most down-beam electron-optical element of the charged particle device, there may be a close, e.g. of similar distance, separation between the most down-beam electron-optical element and the sample (e.g. about 100 micron). In an embodiment, electrodes to capture the signal charged particles are formed in the top metal layer of the CMOS device. The electrodes can be formed in other layers of the substrate, e.g. of the CMOS chip. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In an embodiment, a single electrode surrounds at least some of the apertures. In an arrangement a single electrode is assigned for example around each aperture. In another embodiment, a plurality of electrode elements are provided around each aperture for example as a detector element. The signal charged particles captured by the electrode elements surrounding one aperture may be combined into a single detection signal or used to generate independent detection signals. The electrode elements may be divided radially (i.e., to form a plurality of concentric annuluses), angularly (i.e., to form a plurality of sector-like pieces), both radially and angularly (providing an arrangement like a dart board), or in a grid (for example as a chess board) or in any other convenient manner.

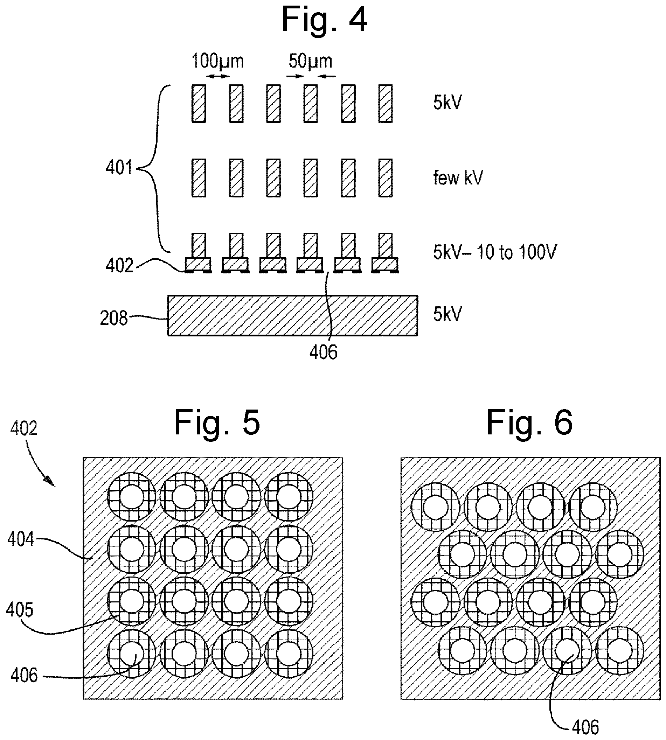

An exemplary embodiment of a detector integrated into an objective lens array 401 is shown in **FIG. 4**, which illustrates a portion of an objective lens array 401 in schematic cross section. In this embodiment, the detector comprises a detector module 402 comprising a plurality (e.g., an array) of detector elements 405 (e.g., sensor elements such as capture electrodes) preferably as an array of detector elements (i.e. a plurality of detector elements in a pattern or arrangement preferably over a two dimensional surface). In this embodiment, the detector module 402 is provided on an output side of the objective lens array. The output side is the output side of the objective lens array 401. **FIG. 5** is a bottom view of detector module 402 which comprises a substrate 404 on which are provided a plurality of detector elements (or capture electrodes 405) each surrounding a beam aperture 406. The beam apertures 406 may be formed by etching through substrate 404. In the arrangement shown in **FIG. 5**, the beam apertures 406 are shown in a rectangular array. The beam apertures 406 can also be differently arranged, e.g. in a hexagonal close packed array as depicted in **FIG. 6.**

The integrated detector module 402 described above is particularly advantageous when used with an assessment apparatus (e.g. comprising a device) having tunable landing energy because secondary electron capture can be optimized for a range of landing energies. A detector module having or in the form of an array can also be integrated into other electrode arrays, not only the lowest electrode array. Further details and alternative arrangements of a detector module integrated into an objective lens can be found in EP Application Number 20184160.8, which document is hereby incorporated by reference.

An electric power source may be provided to apply respective potentials to electrodes of the control lenses of the control lens array 250 and the objective lenses of the objective lens array 401 and the condenser lenses of the condenser lens array or any electron-optical component of the charged particle device 41 for example the detector module (such as when integrated into the objective lens array or when the objective lens and detector module are separate components). A controller 50 may control the potentials applied to the electron-optical components such as the electrodes of the condenser lens array, objective lens array and/or control lens array.

The charged particle device 41 may comprise other electron-optical components such as charged particle correctors, for example as corrector arrays for alignment of the source to the sample and between beams of the multi-beam and for adjusting the focus of different groups of the beam grid, or individual beams of the beam grid. Such correctors may be controlled to operate dynamically and/or statically, for example during step-up, servicing or during calibration of the charged particle device 41.

In an embodiment, an array of charged particle devices (or device array) is provided. The array may comprise a plurality of any of the charged particle devices (e.g., electron-optical columns) described herein. Each of the charged particle devices in the array focuses respective pluralities of charged particle beams onto different regions of the same sample 208. Each charged particle device in the array may derive a respective plurality of charged particle beams from a different respective source 201. Each respective source 201 may be one source in a plurality of sources 201. At least a subset of the plurality of sources 201 may be provided as a source array. The source array may comprise a plurality of emitters on a common substrate. The focusing of pluralities of charged particle beams from different charged particle devices simultaneously onto different regions of the same sample allows an increased area of the sample 208 to be exposed to charged particle beams simultaneously. Therefore, an increased area of the sample may be processed (e.g. assessed) at one time. The charged particle devices in the device array may be arranged adjacent to each other so as to project the respective pluralities of beams onto adjacent regions of the sample 208. Any number of charged particle devices may be used in the array. Preferably, the number of charged particle devices is in the range of 9 to 200. Each charged particle device in the array may be configured in any of the ways described herein when referring to a single charged particle device, electron-optical device or system or column. Alternatively or additionally, one or more of the charged particle device in the array may be configured to project a single beam.

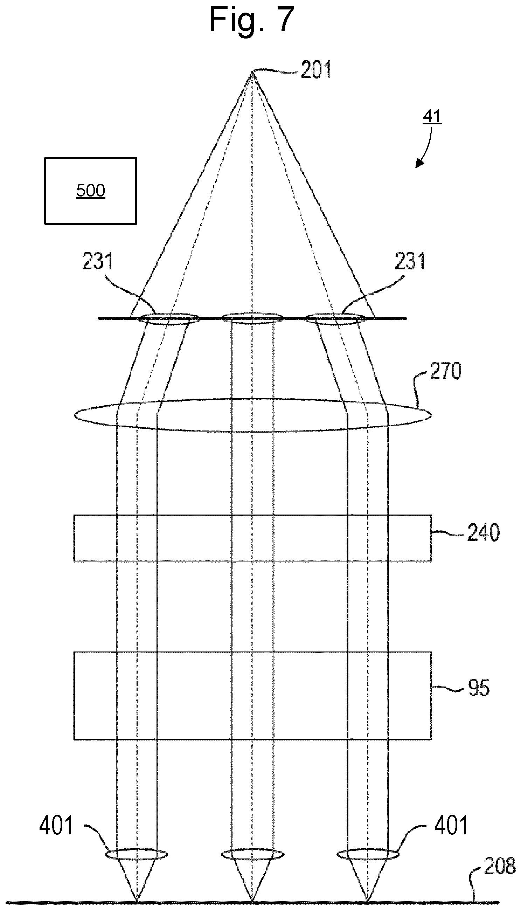

**FIG. 7** schematically depicts a further example of a charged particle device 41. Features that are the same as those described above are given the same reference numerals. For conciseness, such features are not described in detail with reference to **FIG. 7**. For example, the source 201, the condenser lenses 231, the objective lens array 401 and the sample 208 (e.g., on a sample support 207) may be as described above. In this example, a macro collimator 270 is provided instead of a deflector array of the type described above with reference to **FIG. 3**. Such a macro collimator may be a macro lens that may be magnetic, electrostatic or both. In other embodiments, a deflector array may be used to at least contribute to the collimation of the beams, so the deflector array is for finer deflection towards collimation than the action of the macro collimator 270. Such an arrangement may also comprise an array of multiple deflectors (for example in which each aperture has multiple electrodes) for even finer collimation. In an arrangement the condenser lenses 231 may comprise a single plate defining a beam limiting aperture array in which are defined a plurality of apertures with one or more associated macro electrodes with a single aperture. Such a beam limiting aperture array and an associated macro electrode may also form a condenser lens array to focus the generated beams in an intermediate focus which desirably corresponds to the position of the collimator 270.

As described above, in some embodiments a detector may be provided between the objective lens array 401 and the sample 208. The detector may face the sample 208. Alternatively, as shown in **FIG. 7**, the detector 240 may be implemented such that the objective lens array 401 is between the detector 240 and the sample 208.

In an embodiment a deflector array 95 is provided between the detector 240 and the objective lens array 401. In an embodiment the deflector array 95 comprises a Wien filter array so that deflector array 95 may be referred to as a beam separator. The deflector array 95 is configured to provide a magnetic field and an electrostatic filed. The electrostatic and magnetic fields operate together to separate the charged particles projected to the sample 208 relative to the signal particles e.g. electrons from the sample 208. The operation of the fields directs the signal particles towards the detector 240.

In an embodiment the detector 240 is configured to detect signal particles by reference to the energy of the charged particle, i.e. dependent on a band gap, such a semiconductor based type of detector. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the beams that are positioned up beam along the primary beam path with respect to the Wien filter. Primary beams passing through the Wien filter array (of magnetic and electrostatic strips orthogonal to the primary beam path) have paths upbeam and downbeam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the charged particle device. In an embodiment photon coupling may be by via a photon transport unit (e.g., an array of optical fibers) to a remote optical detector which generates a detection signal on detection of a photon.

As mentioned in the introductory part of the description, degassing stimulated by charged particles impinging on a sample can cause unwanted deposition of materials on components exposed to the gases produced by the degassing. This is particularly problematic in arrangements where it is difficult to pump gases away sufficiently well. This may arise where a gap between the sample and a charged particle device used to direct charged particles onto the sample is very small and/or where contamination-sensitive components are positioned near the sample. An example of a contamination-sensitive component is a detector. The problem may therefore arise particularly in arrangements where a detector is positioned close to the sample 208, such as between the sample 208 and an objective lens array 401 (as in **FIG. 3**), or within the objective lens array 401, for example at a distance less than about 200 microns, such as less than about 100 microns, less than about 75 microns, less than about 50 microns, less than about 20 microns, or equal to or less than about 10 microns. In these situations, it will be difficult or impossible to prevent a significant proportion of gases originating from charged particle stimulated degassing (which may also be referred to as charged particle stimulated desorption or, in the case of electrons, electron stimulated desorption) from passing into a charged particle device adjacent to the sample. The gases may pass via holes in the charged particle device, such as via apertures for implementing electrostatic lenses or for acting as beam limiting apertures. The gases may reach contamination-sensitive components via the holes.

Hydrocarbons ($C_xH_y$), particularly hydrocarbons having a molecular weight equal to or greater than about 50, are typically of most concern in the degassed gas as these can lead to damaging deposition of carbon on contamination-sensitive elements (e.g., detectors). Degassing will typically be higher where charged particles are used to perform after development inspection (ADI) in comparison to after etch inspection (AEI). However, in both cases there will be scenarios where degassing of hydrocarbons is too high to avoid deposition problems if no countermeasures are taken. For example, even in AEI outgassing rates of up to around 0.3 molecules per electron or higher have been observed. If around 1% of the outgassed molecules are hydrocarbons, this would result in partial pressures of hydrocarbons being 1 to 10 times too high to avoid significant growth of carbon on contamination-sensitive components. Embodiments of the disclosure described below aim to address these issues, particularly to reduce or avoid problematic deposition of material on contamination-sensitive components.

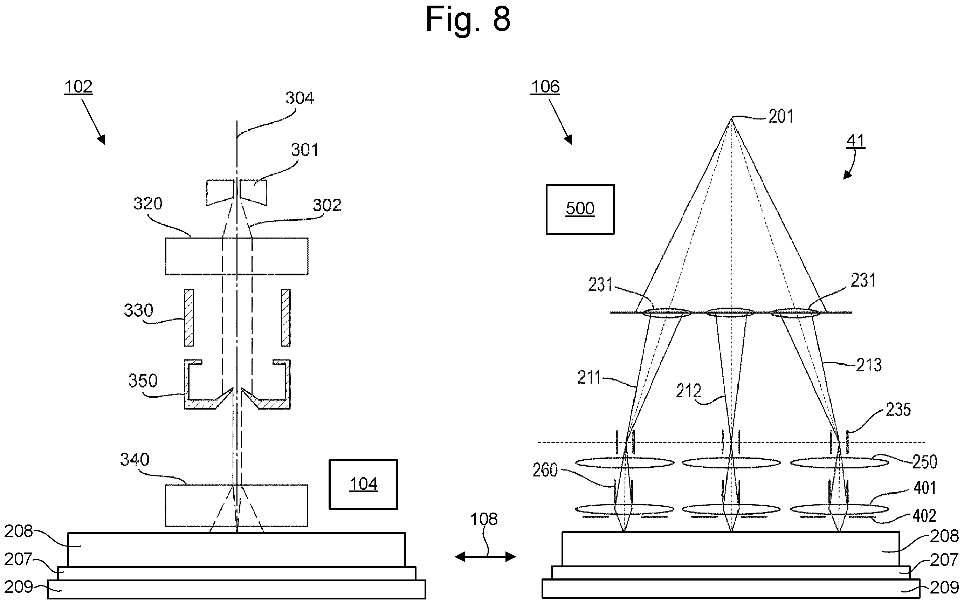

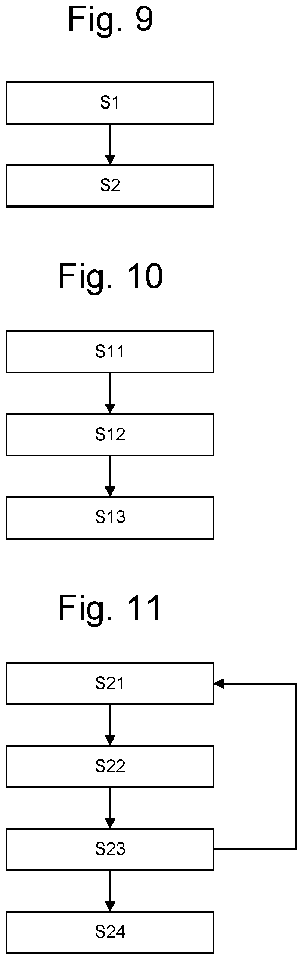

**FIG. 8** depicts an apparatus for assessing a sample 208 using charged particles (e.g., electrons). The apparatus comprises a degassing device 102, a degassing sensor 104, an assessment device 106, and a control system 500. The control system 500 controls the apparatus to perform various functions as described below. The control system 500 may comprise or consist of a controller 50 taking any of the forms described above with reference to **FIG. 1**. The control system 500 may comprise a single unit configured to perform all of the control functionality or may comprise a distributed system of units that together allow the required functionalities to be achieved. The control system 500 may be at least partially computer implemented. Any suitable combination of elements (e.g., CPUs, RAM, data storage, data connections, sensors, etc.) may be provided and suitably programmed to achieve some or even all the specified functionality. Any reference herein to an apparatus, device or system being configured to perform functionality is intended to encompass the case where the control system 500 is configured to cause the functionality to be performed (e.g., by being suitably programmed to provide control signals that cause the functionality to happen). The apparatus is an example of an apparatus that can be used to perform the methods described below with reference to **FIG. 9-11.**

In an embodiment, as exemplified in the flow chart of **FIG. 9**, a sample is assessed by performing steps S1 and S2.

In step S1, a degassing action is performed by exposing a target area of a sample with charged particles. The charged particles stimulate degassing (e.g., via electron stimulated desorption). The degassing action may be performed by the degassing device 102 shown in **FIG. 8**. The degassing device 102 may thus be configured to expose a target area of the sample 208 with charged particles to stimulate degassing from the target area. A rate of degassing from the target area is measured during the degassing action, for example by the degassing sensor 104 shown in **FIG. 8**. A rate of degassing may thus be measured while the target area is being exposed by the degassing device 102.

In step S2, an assessing of the sample 208 is performed, for example using the assessment device 106 of **FIG.**

8. Initiation of the assessing is controlled, for example by the control system 500 of **FIG. 8**, based on a characteristic of the measured rate of degassing. The characteristic of the measured rate of degassing may, for example, be a magnitude of the measured rate of degassing or a rate of change with time of the magnitude of the measured rate of degassing, or a combination thereof. The assessing comprises exposing the target area with charged particles and detecting signal charged particles from the target area. The assessing may comprise assessing defects in the target area of the sample 208 and/or assessing the relative dimensions of, e.g. the measurement of, structures in and/or on the target area of the sample. The assessing may be referred to as an inspection process and/or a measurement process.

Thus, a method is provided in which degassing of a target area on a sample 208 is deliberately stimulated by charged particles and a result of that stimulation is monitored by measuring the rate of degassing. As particles prone to charged particle stimulated degassing leave the sample 208 during the degassing action the rate of stimulated degassing will gradually reduce. The rate of degassing expected in any later exposure of the target area by charged particles will also reduce. Measuring the rate of degassing during the degassing action in step S1 thus provides information about the extent to which degassing will be lower in step S2 during the assessing of the sample via exposure with charged particles. Controlling the initiation of the assessing of the sample 208 in step S2 based on a characteristic of the measured rate of degassing thus allows the assessing of the sample 208 to be initiated only when degassing will be at an acceptably low level. The acceptably low level may, for example, correspond to a level at which deposition of carbon on contamination-sensitive components due to the degassing will be at an acceptably low level or will not happen at all to a significant extent. The acceptably low level may correspond to a threshold count of the number of molecules degassed per charged particle impinging on the target area, for example, to a rate of degassing of about 0.01, desirably about $1 \times 10^{-3}$, desirably about $1 \times 10^{-4}$, desirably about $1 \times 10^{-5}$, molecules of hydrocarbon per charged particle impinging on the target area.

In an embodiment, a time averaged current of charged particles received by the target area is higher, optionally at least 2 times higher, optionally at least 5 times higher, optionally at least 10 times higher, optionally at least 50 times higher, optionally at least 75 times higher, optionally at least 100 times higher, during exposure of the target area during the degassing action of step S1 than during the assessing of the sample in step S2. Providing a higher current of charged particles speeds up the degassing action, thereby improving throughout. For example, by providing a 100 times higher current during the degassing action it is possible to provide 10 times the charged particle dose to the target area in a time period that is 10 times shorter, e.g. than the time used for assessing. It has been observed that exposing a sample to charged particles to stimulate degassing in a degassing action prior to assessing a sample reduces degassing during the assessing of the sample in a manner that is correlated with, typically proportional to, the dose of charged particles used in the degassing action.

Alternatively or additionally, a landing energy of the charged particles received by the target area may be lower, optionally at least 2 times lower, optionally at least 5 times lower, optionally at least 10 times lower, optionally at least 50 times lower, optionally at least 75 times lower, optionally at least 100 times lower, during the degassing action of step S1 than during the assessing of the sample in step S2. In an embodiment, the landing energy of the charged particles received by the target area during the degassing action of step S1 is equal to or lower than 1000eV, optionally equal to or lower than 500eV, optionally equal to or lower than 250eV, optionally equal to about 100eV. Lowering the landing energy during the degassing action may speed up the degassing action by increasing the efficiency with which the charged particles stimulate degassing, thereby improving throughput. Lowering the landing energy also makes it more difficult to focus the charged particles so it is desirable not to reduce landing energies too far. Typically, landing energies of about 100eV or higher will allow spot size to be controlled adequately during the degassing action (where only relatively coarse focusing is normally needed).

In an embodiment, the exposing of the target area during the degassing process comprises a flood exposure. The degassing device 102 may comprise a flood column configured to provide the flood exposure . **FIG. 8** depicts an example configuration for a flood column in a degassing device 102, although other electron-optical designs of flood column may be used. In this example, the flood column comprises a charged particle source 301, a condenser lens 320, a blanker electrode 330, an objective lens 340 and an aperture body 350. The flood column 300 may also comprise additional components for manipulation of the charged particle beam 302 such as a scanning element (not shown) and a field lens (not shown). The components of the flood column 300 may be arranged substantially along an axis 304.

The charged particle source 301 may be an electron source. The charged particle source 301 may comprise a charged particle emitting electrode (e.g. a cathode) and an accelerating electrode (e.g. an anode). The charged particles are extracted or accelerated from the charged particle emitting electrode by the accelerating electrode to form a charged particle beam 302. The charged particle beam 302 may propagate along a beam path 302. The beam path 302 may comprise the axis 304, for example in situations in which the charged particle beam 302 is not deflected away from the axis 304.

The condenser lens 320 is positioned down-beam of the charged particle source 301, i.e. the condenser lens 320 is positioned in a down-beam direction relative to the charged particle source 301. The condenser lens 320 may focus or defocus the charged particle beam 302. As shown in **FIG. 8**, the condenser lens 320 may be used to collimate the charged particle beam 302. However, the condenser lens 320 may also be used to control the charged particle beam 302 to create a divergent beam or a convergent beam.

The aperture body 350 may be positioned down-beam of the condenser lens 320. The aperture body 350 may pass a portion, or only a portion and not all, of a charged particle beam propagating along an axis 304. The aperture body 350 may limit the lateral extent of the charged particle beam 302, as depicted in **FIG. 8**. The aperture body 350 may also be used to selectively blank the charged particle beam 302, so as to prevent passage of any portion of the charged particle beam 302. The aperture body 350 may define an opening. If the lateral extent (or diameter) of the charged particle beam 302 is larger than the lateral extent (or diameter) of the opening, then only a portion of the charged particle beam 302 will pass through the opening. The aperture body 350 may thus limit the lateral extent of the charged particle beam 302, so as to act as a beam-limiting aperture.

The blanking electrode 330 may be positioned down-beam of the condenser lens 320 and up-beam of the aperture body 350. The blanking electrode 330 may selectively deflect the charged particle beam 302, for example deflect the charged particle beam 302 away from the axis 304. The blanking electrode 330 may deflect the charged particle beam 302 away from the opening in the aperture body 350, for example onto a portion of the aperture body 350 that does not comprise the opening, so as to prevent any portion of the charged particle beam 302 from passing through the opening defined by the aperture body 350. The blanking electrode 330 may blank the beam so that beam does not pass through the opening of the aperture body 350. However, the combination of the blanking electrode 330 and the aperture body 350 may also be used to selectively blank the charged particle beam 302, i.e. to selectively prevent passage of at least part the charged particle beam 302 through the opening in the aperture body 350. That is, the combination of the blanking electrode 330 and the aperture body 350 may selectively control the proportion of the charged particle beam 302 that passes the opening.

The objective lens 340 is positioned down-beam of the aperture body 350. The objective lens 340 may focus or defocus the charged particle beam 302. As shown in **FIG. 8**, the objective lens 320 may be used to control the charged particle beam 302 so as to create a divergent beam, thereby increasing the spot size on the sample 208 and increasing the area of the surface on the sample 208 that is flooded with charged particles. However, in some situations, the objective lens 340 may be used to control the charged particle 302 so as to create a convergent beam, thereby focusing the charged particle beam 302 onto the sample 208.

In an embodiment, the assessment device 106 exposes the sample 208 with a multi-beam of charged particles, the multi-beam comprising a plurality of individual beams of charged particles. The example of **FIG. 8** shows a multi-beam comprising three individual beams but in practice the multi-beam may comprise many tens, hundreds or thousands of beams.

In an embodiment, the assessment device 106 comprises a charged particle device 41. The charged particle device 41 may take any of the forms described above with reference to **FIG. 3** and **7** for example,. In the particular example of **FIG. 8** the assessment device 106 corresponds to the arrangement of **FIG. 3** and may operate and/or take any of the forms described above with reference to **FIG. 3**. The charged particle device 41 is used during the assessing of the sample 208 in step S2 to direct the charged particles onto the sample 208 and to detect the signal charged particles from the sample 208. The charged particle device 41 comprises a contamination-sensitive component. In an embodiment, the detecting of signal charged particles is performed using the contamination-sensitive component. The contamination-sensitive component may therefore comprise, or consist of, at least a portion of the detector. The charged particle device 41 is arranged such that the contamination-sensitive component is less vulnerable to contamination from charged particle stimulated deposition due to outgassing from the target area during the degassing action in step S1 than during the assessing of the sample 208 in step S2. Thus, for a given rate of degassing from the target area, the contamination-sensitive component will be less vulnerable to contamination by deposition during step S1 than during step S2.

The contamination-sensitive component may be less vulnerable to contamination due to being further away from the target area during the degassing action in step S1 compared to during the assessing of the sample 208 in step S2. Alternatively or additionally, the contamination-sensitive component may made less vulnerable to contamination by reducing or eliminating impingement of charged particles onto the contamination-sensitive component during the degassing action in step S1 compared to during the assessing of the sample 208 in step S2. The charged particle device 41 may, for example, suppress propagation of charged particles from a source 201 of the charged particle device 41 to the contamination-sensitive component. In an embodiment, the control system 500 switches the assessment device into a blocking mode during at least part of the degassing action in step S1 (e.g., during the exposing of the target area of the sample with charged particles by the degassing device 102). The blocking mode may be implemented using any suitable technique for blocking propagation of charged particles from the source 201 to contamination-sensitive components. In the arrangement shown in **FIG. 8**, for example, the blocking mode may be implemented by controlling potentials applied to electrodes of the condenser lens array 231 to cause the condenser lens array 231 to repel charged particles back towards the source 201 and/or to re-direct the charged particles to be absorbed in a charged particle sink and/or otherwise not to travel through apertures in the control lens array 250 and/or objective lens array 401 to the detector module 402. Additionally or alternatively, the charged particle device may comprise a deflector configured to deflect the charged particles so they do not reach the sample. For example a deflector array is positioned along the paths of the plurality of beams down beam of the condenser lens array. During blocking, such a deflector array may be controlled to direct the beams away from the corresponding apertures of each beam in the objective lens array so that the beams impact a blocking surface of the objective lens array or a plate along the paths of the charged particle beams with apertures for each beam and serves as a blocking surface.

In an embodiment, as exemplified in **FIG. 8**, the degassing action in step S1 and the assessing of the sample 208 in step S2 are performed using charged particle beams from sources 301, 201 in different respective charged particle devices to expose the target area with charged particles. In such an embodiment, the degassing device 102 may perform the exposing of the target area of the sample with charged particles to stimulate degassing (i.e., the degassing action of step S1) when the target area of the sample 208 is positioned in a processing zone of the degassing device 102. In the example of **FIG. 8**, the processing zone of the degassing device 102 corresponds to a zone where the sample 208 is opposite to the charged particle device of the degassing device 102 (i.e., on the left side of the diagram in **FIG. 8**). The assessment device 106 performs the exposing of the target area of the sample with charged particles and detecting of signal charged particles from the target area (i.e., the assessing of the sample in step S2) when the target area of the sample 208 is positioned in a processing zone of the assessment device 106 (i.e., on the right side of the diagram in **FIG. 8**). The control system 500 controls the sample support 207, 209 to move the sample 208 from the processing zone of the degassing device 102 to the processing zone of the assessment device 106 between the exposing of the target area with charged particles by the degassing device 102 and the exposing of the target area with charged particles by the assessment device 106. The control system 500 may thus control the sample support 207, 209 to move the sample 208 in a direction with a lateral component (left to right in **FIG. 8**), as indicated schematically by arrow 108 in **FIG. 8**. In such embodiments, the degassing sensor 104 measures the rate of degassing while the target area is in the processing zone of the degassing device 102 (i.e., on the left in **FIG. 8**).

In an alternative embodiment, the degassing device 102 and the assessment device 104 comprise a common charged particle device 41 with a common source 201, 301 or an arrangement with two different sources 201, 301 with a primary charged particle device for assessment with a merging secondary column for the degassing device 102. For example, the arrangement of **FIG. 3** could be used to perform both the degassing action of step S1 and the assessing of the sample of step S2. In embodiments of this type, the control system 500 may control the sample support 207, 209 and assessment device 106 to move the sample 208 or at least a portion of the common charged particle device 41 such that the sample 208 is further away from the common charged particle device between the exposing of the target area with charged particles to stimulate degassing (i.e., the degassing action of step S1) and the exposing of the target area with charged particles and detecting of signal charged particles (i.e., the assessing of the sample of step S2). Thus, a larger gap may be provided above the sample 208 during the degassing action of step S1 than during the assessing of the sample 208 of step S2. A larger gap may facilitate pumping away of particles during the degassing action and thereby reduce or avoid any contamination of components during the degassing action.

In an embodiment, the degassing sensor 104 is configured to measure a characteristic of a gas in a volume fluidically connected to the target area of the sample 208 while the target area is being exposed with charged particles by the degassing device 102 (e.g., during the degassing action of step S1). The volume is a volume that is influenced by the degassing action. Gas produced by the degassing action enters the volume and is detectable in the volume. The degassing sensor 104 may be positioned and/or mounted in any way that allows the functionality to be performed. The degassing sensor 104 may, for example, be supported by a vacuum wall such as on a flange onto which a charged particle device is mounted. Alternatively, the degassing sensor 104 may be provided as part of a charged particle device, such as a charged particle device configured to expose the target area with charged particles during the degassing action of step S1 (e.g., as part of a flood column). In an embodiment, the degassing sensor 104 is configured to measure a partial pressure of a component of interest in the gas. The degassing sensor 104 may comprise a residual gas analyzer (RGA). The component of interest in the gas may comprise hydrocarbons, particularly hydrocarbons having a molecular weight equal to or greater than about 50. Changes in the partial pressure of hydrocarbons caused by the degassing action have been found to be high enough to be detectable with high accuracy. This is particularly the case where high currents of charged particles are used during the degassing action. For example, in an example implementation with a starting rate of degassing of 0.3 molecules per charged particle with 1% hydrocarbons ($C_xH_y$) and a final rate of degassing of 0.03 molecules per charged particle with 1 % hydrocarbons ($C_xH_y$), an outgassing rate $Q_{C_xH_y}$ with a current of 200μA of impinging charged particles is given by the following expression:

$$Q_{C_xH_y} = 200\mu A \times 0.03 \times 1\% \times \frac{k_B \times 300K}{Q_e} = 1.55 \times 10^{-8} \text{mbar} \cdot \frac{\text{L}}{\text{s}}$$

where $k_B$ is Boltzmann's constant and $Q_e$ is the charge of an electron. If a volume above the sample is pumped with 10L/s the pressure of $C_xH_y$ in the volume, $P_{C_xH_y}$ would be given by the following expression:

$$P_{C_xH_y} = \frac{Q_{C_xH_y}}{10L/s} = 1.55 \times 10^{-9}\,\text{mbar}$$

It is possible to measure increases in partial pressure of this magnitude relative to typical background partial pressures of $C_xH_y$, for example using an RGA (a residual gas analyser). This is especially the case because the partial pressure will undergo a sharp change as soon as the exposure of the sample with charged particles in the degassing action is interrupted. It is thus easy to distinguish between a contribution to the partial pressure from the degassing action and a contribution to the partial pressure from background levels of $C_xH_y$. Even if the background level of $C_xH_y$ is larger than the partial pressure change caused by the degassing action, the partial pressure change caused by the degassing action will be observable.

A background level of relevant gases (e.g., hydrocarbons having a molecular weight equal to or greater than a threshold weight e.g. 50) may be present independently of the degassing action. Measurements of the partial pressure of components of interest may in such cases comprise both a contribution from the background and a contribution from the degassing action of step S1. In some embodiments, a background characteristic of the gas in the volume may be measured. The background characteristic of the gas in the volume may be measured outside of a time period of the degassing action in step S1 (i.e., while the degassing action is not being performed). The background characteristic may comprise a partial pressure of a component of interest in the gas. Measuring the partial pressure of the component of interest during the degassing action and outside of the degassing action makes it possible to separate the background level of the component of interest from the partial pressure of the component of interest resulting from the degassing action (stimulated by the exposure with charged particles in step S1). Thus, the assessing of the sample in step S2 may be initiated based on both: the characteristic of the gas measured during the degassing action in step S1; and the background characteristic of the gas measured outside of the time period of the degassing action. **FIG. 10** and **11** depict example variations on the methodology of **FIG. 9** that include such measurements of background characteristics.

In the variation of **FIG. 10**, the background characteristic of the gas is measured in a preliminary step S11 before a degassing action is performed in step S12. The degassing action in step S 12 may take any of the forms described above with reference to step S1 of **FIG. 9**. The degassing action of step S12 may be followed by a step S13 of assessing the sample 208 by exposing the target area with charged particles and detecting signal charged particles from the target area. Step S11 provides the measured background characteristic so step S13 (e.g., via control system 500) can directly take account of the measured background characteristic to control initiation of the assessing of the sample 208. The step S13 may otherwise take any of the forms described above with reference to step S2 of **FIG. 9.**

In the variation of **FIG. 11**, the degassing action is performed in step S21 and may take any of the forms described above with reference to step S1 of **FIG. 9**. The degassing action in step S21 is followed in step S22 by measuring of the background characteristic of the gas. The background characteristic of the gas is thus measured after the degassing action in step S21 in this embodiment. In step S23, the measured background characteristic of the gas (e.g., background partial pressure of hydrocarbons) is compared to (e.g., subtracted from) the characteristic of the gas measured during the degassing action (e.g., partial pressure of hydrocarbons including a contribution from the degassing action). This allows a rate of degassing due to the degassing action to be deduced more accurately. If the rate of degassing due to the degassing action is determined to be sufficiently low then the method continues to step S24. Step S24 comprises assessing the sample 208 by exposing the target area with charged particles and detecting signal charged particles from the target area. The step S24 may take any of the forms described above with reference to step S2 of **FIG. 9**. If the rate of degassing due to the degassing action is determined in step S23 to not yet be low enough then steps S21 (degassing action) and, optionally, step S22 (measuring the background) may be repeated and then step S23 performed again to check whether the degassing due the degassing action is low enough to proceed to the step S24 (assessing of the sample 208). Steps S21, S22 and S23 may thus be performed repeatedly, e.g. iteratively, until it is determined that the degassing action has sufficiently reduced degassing to allow the assessing of the sample 208 of step S24 to safely proceed. Repeating step S22 may allow drifts in the background level of components of interest to be monitored and thereby improve accuracy. In some embodiments, however, step S22 may be omitted from the repetition. This may be appropriate, for example, where the background characteristics of the gas are expected to be of low importance (e.g., containing levels of problematic hydrocarbons that are significantly lower than those produced by the degassing action) and/or relatively stable over time (such that a single performance of step S22 provides a measure of the background characteristics of the gas that remains sufficiently accurate over relevant time scales).

In an embodiment, the measuring of the characteristic of the gas comprises measuring a pressure of the gas. Although a component of interest in the gas (e.g., hydrocarbons) may only represent a relatively small proportion of the gas (e.g., around 1%), measuring the overall pressure of the gas may still provide useful information about the level of degassing caused by the degassing action. The rate of degassing of a component of interest (e.g., hydrocarbons) may for example be proportional to, or otherwise correlated with, the overall rate of degassing.

In an embodiment, the assessing of the sample (e.g., in steps S2, S13, S24) is initiated in response to the characteristic of the rate of degassing being determined to have met a condition. The methodology may therefore comprise determining when the characteristic of the rate of degassing meets the condition. In an embodiment, the determination process is performed continuously or at regular intervals during the degassing action until the condition is met. In an embodiment, the condition comprises the rate of degassing having reached or fallen below a predetermined threshold. The degassing action may be stopped in response to the characteristic of the rate of degassing being determined to have met the condition. The predetermined threshold may for example comprise a rate of degassing that is too low to produce any significant deposition of problematic materials (e.g., carbon) on contamination-sensitive components (e.g., components of the detector). In some embodiments, the predetermined threshold may be about 0.01 molecules degassed per charged particle impinging on the target area.

In the embodiments described above, a rate of degassing caused by a degassing action is measured and used to judge when to initiate an assessing of the sample 208. For example, the assessing of the sample 208 will only be initiated when the degassing rate during the degassing action is judged to be low enough that degassing during the assessing of the sample 208 will not cause problems, such as deposition of carbon onto contamination-sensitive components such as components associated with a detector. It is not, however, essential to measure the degassing during the degassing action to ensure that degassing during the assessing of the sample 208 will be sufficiently low. For example, calibration measurements and/or computational modelling may be performed to determine parameters of the degassing action that will be sufficient to cause the degassing during the assessing of the sample 208 to be sufficiently low. The determined parameters of the degassing action may comprise one or more of the following: duration of the degassing action, current of charged particles during the degassing action, and landing energies of charged particles during the degassing action. In an embodiment, the degassing action is performed until a rate of the stimulated degassing falls below a threshold count of the number of molecules of a component of interest, optionally hydrocarbons, degassed per charged particle impinging on the target area, desirably of 0.01 molecules degassed per charged particle impinging on the target area. Subsequently, the assessing the sample 208 by exposing the target area with charged particles and detecting signal charged particles from the target area is performed.

Degassing is applied to a portion of the sample surface prior to assessment using the assessment device. The surface area of the portion which is degassed is as large or larger than the surface of the sample in the subsequent assessing. In situations when two or more different regions, for example dies, of a sample surface are assessed, for example at the same time, for example in die-to-die mode inspection, two or more different regions of the sample surface are assessed. Prior to such assessment, the respective portions for the different regions are degassed. The different portions may be as large if not larger than the respective regions assessed. Typically the surface area degassed may correspond to the surface area subsequently assessed at the same time in one or more regions of the sample surface.

Although the invention has been described primarily herein for a charged particle device as depicted in and described with reference to **FIG. 3** and **7**, the invention can be applied to a charged particle system having a single beam device or a multibeam device with a common, single magnetic objective lens. Although such systems have components of a charged particle device 41 that are not as close to a sample as the arrangements shown in and described with reference to **FIG. 3** and **7**, contamination may still develop with time and use on components more remote from the sample than the vulnerable components of the charged particle devices 41 shown in **FIG. 3** and **7**, the growth of which contamination may be suppressed by embodiments of the present disclosure.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250 and the objective lens array 241.

References to upper and lower, up and down, above and below, etc. should be understood as referring to directions parallel to the (typically but not always vertical) up-beam and down-beam directions of charged particle beams impinging on the sample 208. Thus, references to up beam and down beam are intended to refer to directions in respect of the beam path independently of any present gravitational field.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

An assessment apparatus, tool or system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:

Clause 1. A method of assessing a sample using charged particles, comprising: performing a degassing action by exposing a target area of a sample with charged particles to stimulate degassing; measuring a rate of degassing from the target area during the degassing action; and controlling initiation of an assessing of the sample based on a characteristic of the measured rate of degassing, the assessing of the sample comprising exposing the target area with charged particles and detecting signal charged particles from the target area.

Clause 2. The method of clause 1, wherein a charged particle device used during the assessing of the sample is arranged such that a contamination-sensitive component of the charged particle device is less vulnerable to contamination from charged particle stimulated deposition due to outgassing from the target area during the degassing action than during the assessing of the sample.

Clause 3. The method of clause 2, wherein the contamination-sensitive component is less vulnerable to contamination by being further away from the target area during the degassing action compared to during the assessing of the sample.

Clause 4. The method of clause 2 or 3, wherein the contamination-sensitive component is less vulnerable to contamination by the charged particle device being configured to reduce or eliminate impingement of charged particles onto the contamination-sensitive component during the degassing action compared to during the assessing of the sample.

Clause 5. The method of clause 4, wherein the charged particle device is configured to reduce or eliminate the impingement of charged particles onto the contamination-sensitive component by suppressing propagation of charged particles from a source of the charged particle device to the contamination-sensitive component.

Clause 6. The method of any of clauses 2-5, wherein the detecting of the signal charged particles is performed using the contamination-sensitive component.

Clause 7. The method of any preceding clause, wherein the degassing action and the assessing of the sample are performed using charged particle beams from sources in different respective charged particle devices to expose the target area with charged particles.

Clause 8. The method of clause 7, wherein the sample is moved between the degassing action and the assessing of the sample from a position in which the target area is in a processing zone of the charged particle device that performs the degassing action to a position in which the target area is in a processing zone of the charged particle device that performs the assessing of the sample.

Clause 9. The method of clause 8, wherein the sample is moved in a direction with a lateral component between the degassing action and the assessing of the sample.

Clause 10. The method of clause 8 or 9, wherein the measuring the rate of degassing is performed while the target area is in the processing zone of the charged particle device that performs the degassing action.

Clause 11. The method of any of clauses 1 to 6, wherein the degassing action and the assessing of the sample are performed using a common charged particle device to expose the target area with charged particles.

Clause 12. The method of clause 11, wherein the sample or at least a portion of the common charged particle device is moved between the degassing action and the assessing of the sample such that the sample is positioned further from the common charged particle device during the degassing action than during the assessing of the sample.

Clause 13. The method of any preceding clause, wherein a time averaged current of charged particles received by the target area is at least 2 times higher during exposure of the target area during the degassing action than during the assessing of the sample.

Clause 14. The method of any preceding clause, wherein a landing energy of charged particles received by the target area is at least 2 times lower during exposure of the target area during the degassing action than during the assessing of the sample.

Clause 15. The method of any preceding clause, wherein a landing energy of charged particles received by the target area is equal to or lower than 1000eV during exposure of the target area during the degassing action.

Clause 16. The method of any preceding clause, wherein the exposing of the target area during the degassing process comprises a flood exposure.

Clause 17. The method of any preceding clause, wherein the exposing of the target area during the assessing of the sample comprises exposure with a multi-beam.

Clause 18. The method of any preceding clause, wherein the measuring the rate of degassing comprises measuring a characteristic of a gas during the degassing action in a volume influenced by the degassing action.

Clause 19. The method of clause 18, further comprising: measuring a background characteristic of the gas in the volume influenced by the degassing action outside of a time period of the degassing action.

Clause 20. The method of clause 19, wherein the controlling initiation of the assessing of the sample based on the characteristic of the measured rate of degassing uses both: the characteristic of the gas measured during the degassing action; and the background characteristic of the gas measured outside of the time period of the degassing action.

Clause 21. The method of any of clauses 18 to 20, wherein the measuring of the characteristic of the gas comprises measuring a pressure of the gas.

Clause 22. The method of any of clauses 18 to 21, wherein the measuring of the characteristic of the gas comprises measuring a partial pressure of a component of interest in the gas, desirably hydrocarbons, desirably hydrocarbons having a molecular weight equal to or greater than a weight threshold desirably about 50.

Clause 23. The method of any preceding clause, comprising: determining when the characteristic of the measured rate of degassing meets a condition, wherein the assessing of the sample is initiated in response to the characteristic of the measured rate of degassing being determined to have met the condition.

Clause 24. The method of clause 23, wherein the condition comprises the measured rate of degassing having reached or fallen below a predetermined threshold.

Clause 25. The method of clause 23 or 24, comprising stopping the degassing action in response to the characteristic of the measured rate of degassing being determined to have met the condition.

Clause 26. The method of any preceding clause, wherein the target area on the sample is an area that has been processed by an etching process.

Clause 27. The method of clause 26, comprising performing the etching process.

Clause 28. A computer program comprising instructions configured to control a processor to perform the method of any of the clauses 1 to 27.

Clause 29. An apparatus for assessing a sample using charged particles, the apparatus comprising: a degassing device configured to expose a target area of the sample with charged particles to stimulate degassing from the target area; a degassing sensor configured to measure a rate of degassing from the target area; an assessment device configured to perform an assessing of the sample by exposing the target area with charged particles and detecting signal charged particles from the target area; and a control system configured to control the assessment device to initiate the assessing of the sample in response an output from the degassing sensor.

Clause 30. The apparatus of clause 29, wherein the assessment device comprises a contamination-sensitive component and is configured such that the contamination-sensitive component is less vulnerable to contamination from charged particle stimulated deposition due to outgassing from the target area during exposure of the target area by the degassing device than during the assessing of the target area by the assessment device.

Clause 31. The apparatus of clause 30, wherein the degassing device and the assessment device are configured such that the contamination-sensitive component is further away from the target area when the target area is being exposed with charged particles by the degassing device than when the target area is being exposed with charged particles by the assessment device.

Clause 32. The apparatus of clause 30 or 31, wherein the assessment device comprises a source and the assessment device is configured to be selectively switchable to a blocking mode in which propagation of charged particles from the source the contamination-sensitive component is suppressed.

Clause 33. The apparatus of any of clauses 30 to 32, wherein the control system is configured to cause the assessment device to be in the blocking mode during at least part of the exposing of the target area of the sample with charged particles by the degassing device.

Clause 34. The apparatus of any of clauses 30 to 33, wherein the assessment device comprises a detector configured to perform the detecting of the signal charged particles and the contamination-sensitive component comprises at least a portion of the detector.

Clause 35. The apparatus of any of clauses 29 to 34, wherein the degassing device and the assessment device comprise different sources of charged particles and different respective charged particle devices for directing charged particles from the sources to the sample.

Clause 36. The apparatus of clause 35, wherein: the apparatus comprises a sample support configured to support the sample; the degassing device is configured to perform the exposing of the target area of the sample with charged particles to stimulate degassing when the target area of the sample is positioned in a processing zone of the degassing device; the assessment device is configured to perform the exposing of the target area of the sample with charged particles and detecting of signal charged particles from the target area when the target area of the sample is positioned in a processing zone of the assessment device; and the control system is configured to control the sample support to move the sample from the processing zone of the degassing device to the processing zone of the assessment device between the exposing of the target area with charged particles by the degassing device and the exposing of the target area with charged particles by the assessment device.

Clause 37. The apparatus of clause 36, wherein control system is configured to control the sample support to move the sample in a direction with a lateral component.

Clause 38. The apparatus of clause 36 or 37, wherein the degassing sensor is configured to measure the rate of degassing while the target area is in the processing zone of the degassing device.

Clause 39. The apparatus of any of clauses 29 to 34, wherein the degassing device and the assessment device comprise a common charged particle device configured to expose the target area with charged particles.

Clause 40. The apparatus of clause 39, wherein: the apparatus comprises a sample support configured to support the sample; and the control system is configured to control the sample support and/or assessment device to move the sample or at least a portion of the common charged particle device such that the sample is further away from the common charged particle device between the exposing of the target area with charged particles to stimulate degassing and the exposing of the target area with charged particles and detecting of signal charged particles.

Clause 41. The apparatus of any of clauses 29 to 40, wherein control system, degassing device and/or assessment device is/are configured such that a time averaged current of charged particles received by the target area is at least 2 times higher during the exposing of the target area with charged particles to stimulate degassing in comparison to during the exposing of the target area with charged particles and detecting of signal charged particles.

Clause 42. The apparatus of any of clauses 29 to 41, wherein the control system is configured to control the degassing device such that a landing energy of charged particles received by the target area is at least 2 times lower during the exposing of the target area with charged particles to stimulate degassing than during the exposing of the target area with charged particles and detecting of signal charged particles.

Clause 43. The apparatus of any of clauses 29 to 42, wherein the control system is configured to control the degassing device such that a landing energy of charged particles received by the target area is equal to or lower than 1000eV during the exposing of the target area with charged particles to stimulate degassing.

Clause 44. The apparatus of any of clauses 29 to 43, wherein the degassing device comprises a flood column configured to provide a flood exposure.

Clause 45. The apparatus of any of clauses 29 to 44, wherein the assessment device is configured to expose the sample with a multi-beam of charged particles, the multi-beam comprising a plurality of individual beams of charged particles.

Clause 46. The apparatus of any of clauses 29 to 45, wherein the degassing sensor is configured to measure a characteristic of a gas in a volume fluidically connected to the target area of the sample while the target area is being exposed with charged particles by the degassing device.

Clause 47. The apparatus of clause 46, wherein the control system is configured to cause the degassing sensor to measure a background characteristic of the gas in the volume outside of a time period while the target area is being exposed with charged particles by the degassing device.

Clause 48. The apparatus of clause 47, wherein the control system is configured such that the control of the assessment device to initiate the assessing of the sample in response to the output from the degassing sensor uses both: the characteristic of the gas measured while the target area is being exposed with charged particles by the degassing device; and the background characteristic of the gas measured outside of the time period while the target area is being exposed with charged particles by the degassing device.

Clause 49. The apparatus of any of clauses 46 to 48, wherein degassing sensor is configured to measure a pressure of the gas.

Clause 50. The apparatus of any of clauses 46 to 49, wherein the degassing sensor is configured to measure a partial pressure of a component of interest in the gas, desirably hydrocarbons, desirably hydrocarbons having a molecular weight equal to or greater than 50.

Clause 51. The apparatus of any of clauses 29 to 50, wherein the control system is configured to: determine when a characteristic of the measured rate of degassing meets a condition; and initiate the assessing of the sample in response to the characteristic of the measured rate of degassing being determined to have met the condition.

Clause 52. The apparatus of clause 51, wherein the condition comprises the measured rate of degassing having reached or fallen below a predetermined threshold.

Clause 53. The apparatus of clause 51 or 52, wherein the control system is configured to stop the exposing of the target area by the degassing device in response to the characteristic of the measured rate of degassing being determined to have met the condition.

Clause 54. A method of assessing a sample using charged particles, comprising: performing a degassing action by exposing a target area of a sample with charged particles to stimulate degassing until a rate of the stimulated degassing falls below a threshold count of the number of molecules of a component of interest, desirably hydrocarbons, degassed per charged particle impinging on the target area, the threshold count desirably being 0.01 molecules degassed per charged particle impinging on the target area; and subsequently assessing the sample by exposing the target area with charged particles and detecting signal charged particles from the target area.

Clause 55. An apparatus for assessing a sample using charged particles, the apparatus comprising: a degassing device configured to expose a target area of the sample with charged particles to stimulate degassing from the target area; an assessment device configured to perform an assessing of the sample by exposing the target area with charged particles and detecting signal charged particles from the target area; and a control system configured to control the assessment device to initiate the assessing of the sample after the degassing device has exposed the target area of the sample with charged particles until a rate of the stimulated degassing has fallen below a threshold count of the number of molecules of a component of interest, desirably hydrocarbons, degassed per charged particle impinging on the target area, the threshold count desirably being 0.01 molecules degassed per charged particle impinging on the target area.

**Claims**

1. A method of assessing a sample using charged particles, comprising:

    performing a degassing action by exposing a target area of a sample with charged particles to stimulate degassing;
    measuring a rate of degassing from the target area during the degassing action; and
    controlling initiation of an assessing of the sample based on a characteristic of the measured rate of degassing, the assessing of the sample comprising exposing the target area with charged particles and detecting signal charged particles from the target area.

2. The method of claim 1, wherein a charged particle device used during the assessing of the sample is arranged such that a contamination-sensitive component of the charged particle device is less vulnerable to contamination from charged particle stimulated deposition due to outgassing from the target area during the degassing action than during the assessing of the sample.

3. The method of claim 2, wherein the contamination-sensitive component is less vulnerable to contamination by being further away from the target area during the degassing action compared to during the assessing of the sample.

4. The method of claim 2 or 3, wherein the contamination-sensitive component is less vulnerable to contamination by the charged particle device being configured to reduce or eliminate impingement of charged particles onto the contamination-sensitive component during the degassing action compared to during the assessing of the sample.

5. The method of claim 4, wherein the charged particle device is configured to reduce or eliminate the impingement of charged particles onto the contamination-sensitive component by suppressing propagation of charged particles from a source of the charged particle device to the contamination-sensitive component.

6. The method of any of claims 2-5, wherein the detecting of the signal charged particles is performed using the contamination-sensitive component.

7. The method of any preceding claim, wherein the degassing action and the assessing of the sample are performed using charged particle beams from sources in different respective charged particle devices to expose the target area with charged particles.

8. The method of claim 7, wherein the sample is moved between the degassing action and the assessing of the sample from a position in which the target area is in a processing zone of the charged particle device that performs the degassing action to a position in which the target area is in a processing zone of the charged particle device that performs the assessing of the sample.

9. The method of claim 8, wherein the sample is moved in a direction with a lateral component between the degassing action and the assessing of the sample.

10. The method of claim 8 or 9, wherein the measuring the rate of degassing is performed while the target area is in the processing zone of the charged particle device that performs the degassing action.

11. The method of any preceding claim, wherein a time averaged current of charged particles received by the target area is at least 2 times higher during exposure of the target area during the degassing action than during the assessing of the sample.

12. The method of any preceding claim, wherein the exposing of the target area during the degassing process comprises a flood exposure.

13. The method of any preceding claim, wherein the exposing of the target area during the assessing of the sample comprises exposure with a multi-beam.

14. The method of any preceding claim, wherein the measuring the rate of degassing comprises measuring a characteristic of a gas during the degassing action in a volume influenced by the degassing action.

15. The method of any preceding claim, comprising:

determining when the characteristic of the measured rate of degassing meets a condition,
wherein the assessing of the sample is initiated in response to the characteristic of the measured rate of degassing being determined to have met the condition.

# Fig. 1

# Fig. 2

# Fig. 3

# Fig. 4

100μm    50μm

401

402

208

5kV

few kV

5kV– 10 to 100V

5kV

406

# Fig. 5

402

404

405

406

# Fig. 6

406

# Fig. 7

Fig. 8

# Fig. 9

```
┌─────────────────┐
│       S1        │
└─────────────────┘
         │
         ▼
┌─────────────────┐
│       S2        │
└─────────────────┘
```

# Fig. 10

```
┌─────────────────┐
│      S11        │
└─────────────────┘
         │
         ▼
┌─────────────────┐
│      S12        │
└─────────────────┘
         │
         ▼
┌─────────────────┐
│      S13        │
└─────────────────┘
```

# Fig. 11

```
┌─────────────────┐
│      S21        │◄───┐
└─────────────────┘    │
         │             │
         ▼             │
┌─────────────────┐    │
│      S22        │    │
└─────────────────┘    │
         │             │
         ▼             │
┌─────────────────┐    │
│      S23        │────┘
└─────────────────┘
         │
         ▼
┌─────────────────┐
│      S24        │
└─────────────────┘
```

**EP 4 306 945 A1**

Europäisches
Patentamt

European
Patent Office

Office européen
des brevets

# EUROPEAN SEARCH REPORT

Application Number

EP 22 18 4150

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2021/116398 A1 (REN WEIMING [US] ET AL) 22 April 2021 (2021-04-22) <br> * abstract * <br> * figures 1-14 * <br> * paragraph [0004] – paragraph [0017] * <br> * paragraph [0030] – paragraph [0117] * <br> ----- | 1-6, 11-15 | INV. <br> G01N23/2202 <br> H01J37/28 <br> H01J37/304 <br><br> ADD. <br> G01N1/44 |
| Y | US 2020/013603 A1 (RUACH-NIR IRIT [IL] ET AL) 9 January 2020 (2020-01-09) <br> * abstract * <br> * figures 1,7-12 * <br> * paragraph [0008] – paragraph [0033] * <br> * paragraph [0050] – paragraph [0086] * <br> * paragraph [0105] – paragraph [0123] * <br> ----- | 1-6, 11-15 | G01N23/203 <br> G01N23/2251 <br> G01N23/2276 |
| A | JP H11 329328 A (HITACHI LTD) 30 November 1999 (1999-11-30) <br> * abstract * <br> * figures 1-6 * <br> * paragraph [0009] – paragraph [0030] * <br> ----- | 1-4,6-9 | |
| A | JP 2002 025497 A (CANON KK) 25 January 2002 (2002-01-25) <br> * abstract * <br> * figures 10,11 * <br> * paragraph [0068] – paragraph [0117] * <br> * paragraph [0133] – paragraph [0140] * <br> * paragraph [0180] – paragraph [0189] * <br> ----- | 1,6 | TECHNICAL FIELDS SEARCHED (IPC) <br><br> B82Y <br> G01N <br> H01J |
| A | US 2021/005423 A1 (ZEIDLER DIRK [DE]) 7 January 2021 (2021-01-07) <br> * the whole document * <br> ----- | 1-15 | |

The present search report has been drawn up for all claims

| Place of search | Date of completion of the search | Examiner |
|---|---|---|
| The Hague | 20 December 2022 | De Kroon, Arnoud |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 18 4150

This annex lists the patent family members relating to the patent documents cited in the above-mentioned European search report.
The members are as contained in the European Patent Office EDP file on
The European Patent Office is in no way liable for these particulars which are merely given for the purpose of information.

20-12-2022

| Patent document cited in search report | | Publication date | Patent family member(s) | | Publication date |
|---|---|---|---|---|---|
| US 2021116398 | A1 | 22-04-2021 | CN | 115151997 A | 04-10-2022 |
| | | | IL | 292290 A | 01-06-2022 |
| | | | KR | 20220062640 A | 17-05-2022 |
| | | | TW | 202131370 A | 16-08-2021 |
| | | | US | 2021116398 A1 | 22-04-2021 |
| | | | US | 2022375712 A1 | 24-11-2022 |
| | | | WO | 2021073868 A1 | 22-04-2021 |
| US 2020013603 | A1 | 09-01-2020 | NONE | | |
| JP H11329328 | A | 30-11-1999 | NONE | | |
| JP 2002025497 | A | 25-01-2002 | NONE | | |
| US 2021005423 | A1 | 07-01-2021 | CN | 112055886 A | 08-12-2020 |
| | | | TW | 201937526 A | 16-09-2019 |
| | | | US | 2021005423 A1 | 07-01-2021 |
| | | | WO | 2019166331 A2 | 06-09-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 21171877 A
- EP 1602121 A1
- EP 20184160